# EUROPÄISCHE PATENTSCHRIFT

(11) **EP 2 297 780 B1**
(45) Veröffentlichungstag und Bekanntmachung des Hinweises auf die Patenterteilung: **12.06.2019**
(21) Anmeldenummer: 09740632.6
(22) Anmeldetag: 25.08.2009
(51) Int. Cl.: H01L 33/62, H01L 23/00, H01L 25/075

(54) **OPTOELEKTRONISCHES MODUL MIT EINEM TRÄGERSUBSTRAT UND EINER MEHRZAHL VON STRAHLUNG EMITTIERENDEN HALBLEITERBAUELEMENTEN UND VERFAHREN ZU DESSEN HERSTELLUNG**
OPTOELECTRONIC MODULE HAVING A CARRIER SUBSTRATE AND A PLURALITY OF RADIATION EMITTING SEMICONDUCTOR DEVICES AND METHOD OF ITS MANUFACTURE
MODULE OPTO-ÉLECTRONIQUE COMPRENANT UN SUBSTRAT DE SUPPORT ET PLUSIEURS DISPOSITIFS SEMICONDUCTEURS ÉMETTANT DE RADIATION, ET PROCÉDÉ DE SA MANUFACTURE

(30) Priorität: 26.09.2008 DE 102008049188
(43) Veröffentlichungstag der Anmeldung: 23.03.2011
(73) Patentinhaber: OSRAM Opto Semiconductors GmbH, 93055 Regensburg (DE)
(72) Erfinder: BRAUNE, Bert, 93173 Wenzenbach (DE); SORG, Jörg Erich, 93053 Regensburg (DE); WEIDNER, Karl, 81245 München (DE); WEGLEITER, Walter, 93152 Nittendorf (DE); WUTZ, Oliver, 93049 Regensburg (DE)
(74) Vertreter: Epping - Hermann - Fischer
(86) Internationale Anmeldenummer: PCT/DE2009/001217
(87) Internationale Veröffentlichungsnummer: WO 2010/034278

(56) Entgegenhaltungen:
- EP-A1- 1 914 814
- EP-A2- 1 724 848
- WO-A2-2005/062389
- DE-A1-102007 011 123
- JP-A- 2004 172 578
- US-A1- 2006 035 036

## Beschreibung

Diese Patentanmeldung beansprucht die Priorität der deutschen Patentanmeldung 10 2008 049 188.8. Die vorliegende Erfindung betrifft ein optoelektronisches Modul mit einem Trägersubstrat und einer Mehrzahl von strahlungsemittierenden Halbleiterbauelementen. Weiterhin betrifft die Erfindung ein Verfahren zum Herstellen eines optoelektronischen Moduls.

JP2004172578 zeigt eine Anordnung einer Mehrzahl von LEDs auf einem Trägersubstrat, welches zur Kontaktierung Leiterbahnen und eine Planarisierungsschicht aufweist.

Bei herkömmlichen optoelektronischen Modulen kommen als elektrische Kontaktiertechniken zwischen einem Chip und einem Träger überwiegend Drahtbonden und Löten oder eine Chipmontage mit Leitkleber zum Einsatz. Auf diese Weise entstehen beispielsweise LED-Arrays für Beleuchtungsmodule. Im Zuge der Miniaturisierung sind immer geringere Dimensionen der Module, wie beispielsweise die Modulhöhe und/oder die Grundfläche der Module, erwünscht.

Eine miniaturisierte Aufbau- und Verbindungstechnik für LEDs ist beispielsweise aus der Offenlegungsschrift DE 10 353 679 A1 bekannt. Hierbei weist ein Bauelement einen Träger mit einem darauf angeordneten Halbleiterchip auf, der planar kontaktiert ist.

Module mit planar kontaktierten Halbleiterchips weisen mit Vorteil eine geringe Bauelementhöhe auf, wodurch vorzugsweise ein minimaler Abstand zwischen der Lichtaustrittsfläche des Halbleiterchips und vorgesehenen optischen Komponenten erzielt werden kann. Die Grundfläche des Moduls kann durch die planare Kontaktierung jedoch nicht ohne weiteres reduziert werden, da auf dem Träger angeordnete Leitstrukturen, die zur elektrischen Kontaktierung der Halbleiterchips dienen, elektrisch isoliert in das Modul integriert werden müssen.

Insbesondere bei Modulen, die eine Mehrzahl von strahlungsemittierenden Halbleiterbauelementen aufweisen, ist eine kompakte Anordnung der optoelektronischen Komponenten auf dem Trägersubstrat erwünscht.

Der Erfindung liegt die Aufgabe zugrunde, ein optoelektronisches Modul bereitzustellen, das insbesondere eine geringe Bauhöhe und gleichzeitig eine kompakte Anordnung einer Mehrzahl von strahlungsemittierenden Halbleiterbauelementen aufweist.

Diese Aufgabe wird durch ein optoelektronisches Modul mit den Merkmalen des Patentanspruchs 1 und ein Verfahren zu dessen Herstellung mit den Merkmalen des Patentanspruchs 6 gelöst. Vorteilhafte Ausführungsformen und bevorzugte Weiterbildungen des Moduls und des Verfahrens zu dessen Herstellung sind Gegenstand der abhängigen Ansprüche.

Es ist ein optoelektronisches Modul vorgesehen, das ein Trägersubstrat und eine Mehrzahl von strahlungsemittierenden Halbleiterbauelementen aufweist. Das Trägersubstrat weist zur elektrischen Kontaktierung der strahlungsemittierenden Halbleiterbauelemente strukturierte Leiterbahnen auf. Die strahlungsemittierenden Halbleiterbauelemente weisen jeweils eine zur Erzeugung von elektromagnetischer Strahlung geeignete aktive Schicht, eine erste Kontaktfläche und eine zweite Kontaktfläche auf, wobei die erste Kontaktfläche jeweils auf der von dem Trägersubstrat abgewandten Seite der strahlungsemittierenden Halbleiterbauelemente angeordnet ist. Die strahlungsemittierenden Halbleiterbauelemente sind mit einer elektrisch isolierenden Schicht versehen, die jeweils eine Aussparung in einem Bereich der ersten Kontaktfläche der strahlungsemittierenden Halbleiterbauelemente aufweist. Auf der elektrisch isolierenden Schicht sind bereichsweise Leitstrukturen angeordnet. Eine der Leitstrukturen verbindet zumindest die erste Kontaktfläche eines strahlungsemittierenden Halbleiterbauelements mit einer weiteren ersten Kontaktfläche eines weiteren strahlungsemittierenden Halbleiterbauelements oder mit einer Leiterbahn des Trägersubstrats elektrisch leitend.

Die elektrische Kontaktierung der strahlungsemittierenden Halbleiterbauelemente erfolgt also nicht durch im Abstand vom Trägersubstrat geführte Drähte, sondern durch eine Leitstruktur, die zumindest teilweise auf der elektrisch isolierenden Schicht geführt ist. Durch diese Art der elektrischen Kontaktierung ergibt sich mit Vorteil eine besonders geringe Bauhöhe des Moduls. Ferner kann durch die Leitstruktur, die die strahlungsemittierenden Halbleiterbauelemente untereinander oder mit einer Leiterbahn des Trägersubstrats elektrisch leitend verbindet, ein kompaktes Modul bereitgestellt werden. So können die strahlungsemittierenden Halbleiterbauelemente des Moduls auf Platz sparende Art und Weise auf dem Trägersubstrat angeordnet werden. Die Grundfläche des Moduls verringert sich so mit Vorteil.

Ferner ist eine nahe Anordnung der Leitstruktur an die strahlungsemittierenden Halbleiterbauelemente möglich. Durch diese Art der Kontaktierung der strahlungsemittierenden Halbleiterbauelemente ergibt sich eine besonders geringe Bauhöhe des Moduls, durch die sich insbesondere eine nahe Anordnung von beispielsweise optischen Elementen an die strahlungsemittierenden Halbleiterbauelemente mit Vorteil ermöglicht.

Unter optischen Elementen sind beispielsweise Linsen zu verstehen. Insbesondere werden unter optischen Elementen Komponenten verstanden, die die von einem Halbleiterbauelement emittierte Strahlung gezielt beeinflussen, insbesondere die Abstrahlcharakteristik ändern.

Die strahlungsemittierenden Halbleiterbauelemente sind bevorzugt Halbleiterchips, besonders bevorzugt Licht emittierende Dioden (LED).

Die strahlungsemittierenden Halbleiterbauelemente weisen jeweils eine aktive Schicht auf. Die aktive Schicht weist jeweils einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung auf. Die Bezeichnung Quantentopfstruktur entfaltet hierbei keine Bedeutung hinsichtlich der Dimensionalität der Quantisierung. Sie umfasst somit unter anderem Quantentröge, Quantendrähte und Quantenpunkte und jede Kombination dieser Strukturen.

Bevorzugt basieren die strahlungsemittierenden Halbleiterbauelemente jeweils auf einem Nitrid-, Phosphid- oder Arsenid-Verbindungshalbleiter. "Auf Nitrid-, Phosphid- oder Arsenid-Verbindungshalbleitern basierend" bedeutet im vorliegenden Zusammenhang, dass die aktive Epitaxieschichtenfolge oder zumindest eine Schicht davon ein III/V-Halbleitermaterial mit der Zusammensetzung InₓGa_{y}Al_{1-x-y}P, InₓGa_{y}Al_{1-x-y}N oder InₓGa_{y}Al_{1-x-y}As, jeweils mit 0 ≤ x ≤ 1, 0 ≤ y ≤ 1 und x + y ≤ 1, umfasst.

In einer bevorzugten Ausgestaltung sind die strahlungsemittierenden Halbleiterbauelemente jeweils als Dünnfilmhalbleiterbauelemente ausgeführt. Als Dünnfilmhalbleiterbauelement wird im Rahmen der Anmeldung ein Halbleiterbauelement angesehen, während dessen Herstellung das Aufwachssubstrat, auf den eine Halbleiterschichtenfolge, die einen Halbleiterkörper des Dünnfilmhalbleiterbauelements umfasst, beispielsweise epitaktisch, aufgewachsen wurde, abgelöst worden ist. Die strahlungsemittierenden Halbleiterbauelemente sind jeweils mit einem Trägersubstrat verbunden, das vom Aufwachssubstrat für die Halbleiterschichtenfolge des Halbleiterbauelements verschieden ist.

Das Trägersubstrat unterliegt mit Vorteil nicht den vergleichsweise hohen Anforderungen, die ein Aufwachssubstrat, etwa hinsichtlich der Kristallstruktur, erfüllen muss. Für die Auswahl des Materials des Trägersubstrats stehen somit mehr Materialien zur Verfügung als für die Auswahl des Materials des Aufwachssubstrats.

Die elektrisch isolierende Schicht ist bevorzugt für die von der aktiven Schicht der strahlungsemittierenden Halbleiterbauelemente emittierte Strahlung zumindest teilweise strahlungsdurchlässig. Die von den strahlungsemittierenden Halbleiterbauelementen emittierte Strahlung kann so durch die elektrisch isolierende Schicht ausgekoppelt werden, ohne dabei wesentliche optische Verluste zu erleiden. Eine Absorption der von der aktiven Schicht emittierten Strahlung in der elektrisch isolierenden Schicht kann dadurch mit Vorteil verringert werden, sodass sich die Effizienz des Moduls mit Vorteil erhöht. Bevorzugt beträgt die Absorption der von der aktiven Schicht emittierten Strahlung der strahlungsemittierenden Halbleiterbauelemente in der elektrisch isolierenden Schicht weniger als 40 %, besonders bevorzugt weniger als 20 %.

Die elektrisch isolierende Schicht ist bevorzugt eine Folie, ein Lack oder eine Polymerschicht.

Bei einer bevorzugten Ausgestaltung enthält die elektrisch isolierende Schicht mindestens ein Konversionselement. Geeignete Konversionselemente, wie etwa ein YAG:Ce Pulver, sind z.B. in der WO98/12757 beschrieben, deren Inhalt insofern hiermit durch Rückbezug aufgenommen wird.

Die strahlungsemittierenden Halbleiterbauelemente emittieren jeweils bevorzugt eine Primärstrahlung mit einer Wellenlänge λ₀. Das Konversionselement in der elektrisch isolierenden Schicht absorbiert bevorzugt zumindest teilweise Strahlung der Wellenlänge λ₀ und emittiert eine Sekundärstrahlung in einem anderen Wellenlängenbereich. Dadurch emittiert das Modul Mischstrahlung, die die Primärstrahlung der strahlungsemittierenden Halbleiterbauelemente und die Sekundärstrahlung des Konversionselements enthält.

Durch eine gezielte Wahl des Konversionselements kann eine Änderung des Farborts der von den strahlungsemittierenden Halbleiterbauelementen emittierten Strahlung erfolgen. Dadurch kann mit Vorteil ein gewünschter Farbort der von dem Modul emittierten Strahlung erzielt werden.

Unter dem Farbort werden im Folgenden die Zahlenwerte verstanden, die die Farbe des emittierten Lichts des Moduls im CIE-Farbraum beschreiben.

Alternativ kann die elektrisch isolierende Schicht mehr als ein Konversionselement enthalten. Dadurch ergibt sich eine Mischstrahlung der von dem Modul emittierten Strahlung, die Primärstrahlung und mehrere Sekundärstrahlungen der mehreren Konversionselemente enthält. Durch die Verwendung von mehr als einem Konversionselement kann mit Vorteil eine genaue Farbselektion des Farborts erfolgen, wodurch sich ein gewünschter Farbort der emittierten Strahlung des Moduls ergibt.

Es sei angemerkt, dass es nicht zwingend erforderlich ist, dass die strahlungsemittierenden Halbleiterbauelemente jeweils Primärstrahlung in demselben Wellenlängenbereich emittieren. Vielmehr können die strahlungsemittierenden Halbleiterbauelemente so ausgebildet sein, dass sie zumindest teilweise Strahlung in unterschiedlichen Wellenlängenbereichen emittieren. Durch eine Überlagerung der von den Halbleiterbauelementen emittierten Strahlung kann so eine von dem Modul emittierte Mischstrahlung erzeugt werden, die sich bevorzugt im weißen Farbbereich des CIE-Farbraums befindet.

Bei einer bevorzugten Ausgestaltung ist zumindest zwischen den einzelnen strahlungsemittierenden Halbleiterbauelementen eine Planarisierungsschicht angeordnet.

Durch die Planarisierungsschicht kann mit Vorteil eine von dem Trägersubstrat abgewandte ebene Oberfläche des Moduls erzielt werden. Bevorzugt ist die elektrisch isolierende Schicht auf dieser ebenen Oberfläche angeordnet. Besonders bevorzugt ist die Planarisierungsschicht elektrisch isolierend.

Bei einer Ausgestaltung des Moduls enthält die Planarisierungsschicht zumindest ein Konversionselement. Besonders bevorzugt absorbiert das Konversionselement von zumindest einem der strahlungsemittierenden Halbleiterbauelemente emittierte Strahlung und konvertiert diese in Strahlung eines anderen Wellenlängenbereichs, sodass Mischstrahlung der von dem Modul emittierten Strahlung erzeugt wird.

Dadurch, dass das Konversionselement oder die Konversionselemente direkt in der elektrisch isolierenden Schicht und/oder in der Planarisierungsschicht integriert sind, sind vorteilhaft keine weiteren optischen Schichten erforderlich. Optische Schichten sind unter anderem Schichten, die den Farbort der von den strahlungsemittierenden Halbleiterbauelementen emittierten Strahlung gezielt verändern und/oder korrigieren. Dadurch, dass das Konversionselement in der elektrisch isolierenden Schicht und/oder der Planarisierungsschicht integriert ist, und die strahlungsemittierenden Halbleiterbauelemente bevorzugt von der Planarisierungsschicht und/oder der elektrisch isolierenden Schicht direkt umgeben sind, erfolgt mit Vorteil eine nahe Konversion der von den strahlungsemittierenden Halbleiterbauelementen emittierten Strahlung an den strahlungsemittierenden Halbleiterbauelementen. Ein kompaktes Modul wird dadurch mit Vorteil ermöglicht.

Die elektrisch isolierende Schicht kann in diesem Fall somit die Funktionen einer Lichtkonversionsschicht, einer Trägerschicht für die Leitstruktur und einer Schutzschicht für die strahlungsemittierenden Bauelemente übernehmen.

Bei einer bevorzugten Ausgestaltung des Moduls sind die strahlungsemittierenden Halbleiterbauelemente gemeinsam von einem Rahmen, der auf dem Trägersubstrat angeordnet ist, umgeben.

Der Rahmen enthält bevorzugt eine Keramik oder einen Kunststoff. Mittels des Rahmens werden die strahlungsemittierenden Halbleiterbauelemente von dem umgebenden Medium räumlich abgegrenzt. Ferner schützt der Rahmen mit Vorteil die strahlungsemittierenden Halbleiterbauelemente vor beispielsweise Umwelteinflüssen, wie beispielsweise Stößen oder Eindringen von Feuchtigkeit.

Bei einer bevorzugten Ausgestaltung des Moduls ist das Trägersubstrat ein flexibles Substrat.

Es ist demnach nicht zwingend notwendig, dass das Trägersubstrat starr ausgebildet ist. Insbesondere kann das Trägersubstrat als Folie ausgebildet sein.

Bei einer bevorzugten Ausgestaltung des Moduls ist die Oberfläche des Trägersubstrats, auf der die strahlungsemittierenden Halbleiterbauelemente angeordnet sind, nicht planar.

Das Trägersubstrat kann somit beispielsweise eine Wölbung aufweisen. Insbesondere kann die Oberfläche des Trägersubstrats auch andere Formungen aufweisen, solange die Montage der strahlungsemittierenden Halbleiterbauelemente auf einer der Oberfläche des Trägersubstrats möglich ist.

Bei einer bevorzugten Ausgestaltung des Moduls sind die Leitstrukturen durch eine anisotrope Schicht gebildet, die auf der elektrisch isolierenden Schicht angeordnet ist und die jeweils zumindest im Bereich der ersten Kontaktfläche der strahlungsemittierenden Halbleiterbauelemente elektrisch leitende Bereiche aufweist.

Die anisotrope Folie weist demnach partiell Bereiche auf, die leitfähig sind. Diese Leitfähigkeit kann beispielsweise durch einen lokal applizierten Druck oder eine Bestrahlung entstehen. Durch die leitfähigen Bereiche der anisotropen Folie wird jeweils ein elektrischer Anschluss der strahlungsemittierenden Halbleiterbauelemente gewährleistet.

Die anisotrope Folie ist bevorzugt zumindest teilweise für die von den Halbleiterbauelementen emittierte Strahlung strahlungsdurchlässig. Insbesondere ist die anisotrope Folie besonders bevorzugt in Bereichen zumindest teilweise für die von den Halbleiterbauelementen emittierte Strahlung strahlungsdurchlässig, in denen keine Leitfähigkeit ausgebildet ist.

Alternativ kann die anisotrope Folie bereichsweise entfernt sein. Insbesondere ist in diesem Fall die anisotrope Folie bevorzugt jeweils im Bereich der Strahlungsaustrittsseite der strahlungsemittierenden Halbleiterbauelemente entfernt.

Bei einer bevorzugten Ausgestaltung des Moduls sind die elektrisch isolierende Schicht über eine strukturierte Leiterplatte und die Leitstrukturen mittels aus der Leiterplatte herausragender elektrisch leitender Stege gebildet.

Die Stege führen bevorzugt jeweils von einer Kontaktstelle einer Leiterbahn der Leiterplatte zu der ersten Kontaktfläche eines strahlungsemittierenden Halbleiterbauelements. Dabei sind die Stege jeweils bevorzugt so geformt, dass sie von der Leiterplatte weg in Richtung der Halbleiterbauelemente gekrümmt sind. Die Leiterplatte weist bevorzugt Aussparungen auf, die besonders bevorzugt jeweils über der ersten Kontaktfläche eines strahlungsemittierenden Halbleiterbauelements angeordnet ist. Bevorzugt sind die Stege Metallstege.

Die Leiterplatte weist bevorzugt Leiterbahnen auf. Die Leiterbahnen der Leiterplatte sind jeweils bevorzugt elektrisch voneinander isoliert angeordnet. Besonders bevorzugt erfolgt diese elektrische Isolierung über die Aussparungen, die einen Abstand zwischen den Leiterbahnen der Leiterplatte erzielen.

Bei dieser Ausgestaltung des Moduls können auch mehrere Leiterplatten übereinander angeordnet sein, sodass eine mehrlagige Anordnung ausgebildet ist. Dadurch sind mit Vorteil mehrere Verschaltungsebenen des Moduls möglich, wodurch mit Vorteil eine höhere Schaltungsintegration in dem Modul erzielt wird.

Bei einer weiteren bevorzugten Ausgestaltung des Moduls ist die elektrisch isolierende Schicht jeweils bereichsweise an den Seitenflächen des jeweiligen strahlungsemittierenden Halbleiterbauelements um das jeweilige strahlungsemittierende Halbleiterbauelement geführt. Jeweils die erste Kontaktfläche der strahlungsemittierenden Halbleiterbauelemente ist dabei so auf der elektrisch isolierenden Schicht geführt, dass jeweils die von dem Trägersubstrat abgewandte Oberfläche der strahlungsemittierenden Halbleiterbauelemente frei von der ersten Kontaktfläche ist.

Durch eine solche Führung der ersten Kontaktschicht wird eine homogene Bestromung der strahlungsemittierenden Halbleiterbauelemente gewährleistet. Ferner ermöglicht es sich so, an beliebigen Bereichen der ersten Kontaktschicht einen externen elektrischen Anschluss der strahlungsemittierenden Halbleiterbauelemente anzuordnen. Bevorzugt ist die elektrisch isolierende Schicht an den Seitenflächen des Halbleiterbauelements über die aktive Schicht des Halbleiterbauelements geführt.

Durch die so geführte erste Kontaktfläche der Halbleiterbauelemente ermöglicht sich ein elektrischer Anschluss der Halbleiterbauelemente oder eine komplexe Verschaltung der Halbleiterbauelemente untereinander. Eine Platz sparende Anordnung der Halbleiterbauelemente auf dem Trägersubstrat ist dadurch mit Vorteil möglich.

Ein Verfahren zum Herstellen eines optoelektronischen Moduls umfasst insbesondere die folgenden Schritte:
a) Anordnen einer Mehrzahl von strahlungsemittierenden Halbleiterbauelementen auf einem Trägersubstrat, wobei das Trägersubstrat zur elektrischen Kontaktierung der strahlungsemittierenden Halbleiterbauelemente strukturierte Leiterbahnen aufweist, die strahlungsemittierenden Halbleiterbauelemente jeweils eine zur Erzeugung von elektromagnetischer Strahlung geeignete aktive Schicht, eine erste Kontaktfläche und eine zweite Kontaktfläche aufweisen, wobei jeweils die erste Kontaktfläche auf der von dem Trägersubstrat abgewandten Seite der strahlungsemittierenden Halbleiterbauelemente angeordnet ist,
b) Aufbringen einer elektrisch isolierenden Schicht auf die strahlungsemittierenden Halbleiterbauelemente, wobei die elektrisch isolierende Schicht jeweils eine Aussparung im Bereich der ersten Kontaktfläche des jeweiligen strahlungsemittierenden Halbleiterbauelements aufweist, und
c) Aufbringen von Leitstrukturen auf Teilbereiche der elektrisch isolierenden Schicht, wobei eine der Leitstrukturen zumindest die erste Kontaktfläche eines strahlungsemittierenden Halbleiterbauelements mit einer weiteren ersten Kontaktfläche eines weiteren strahlungsemittierenden Halbleiterbauelements oder mit einer Leiterbahn des Trägersubstrats elektrisch leitend verbindet.

Vorteilhafte Ausgestaltungen des Verfahrens ergeben sich analog zu den vorteilhaften Ausgestaltungen des Moduls und umgekehrt.

Durch die elektrische Kontaktierung der Halbleiterbauelemente über planare Leitstrukturen minimiert sich mit Vorteil die Höhe des Moduls. Gleichzeitig reduziert sich mit Vorteil die Grundfläche des Moduls vergleichsweise zu herkömmlichen Modulen.

Der Einsatz einer elektrisch isolierenden Schicht, auf der Leitstrukturen zur elektrischen Kontaktierung der Halbleiterbauelemente geführt werden, führt mit Vorteil zu einer Vereinfachung des Aufbauprozesses der Module. Mit Vorteil erfolgt die Verschaltung der Halbleiterbauelemente, die Einkapselung der Halbleiterbauelemente und gegebenenfalls die Lichtkonversion, die bevorzugt durch in der elektrisch isolierenden Schicht integrierte Konversionselemente erfolgt, jeweils mittels eines Beschichtungs-Prozesses.

Bei einer bevorzugten Ausgestaltung des Verfahrens werden die Leitstrukturen mittels eines Druckverfahrens aufgebracht.

Bevorzugt werden die Leitstrukturen auf die elektrisch isolierende Schicht mittels eines Siebdruckverfahrens, eines Schablonendruckverfahrens oder eines Tampondruckverfahrens aufgebracht.

Alternativ können die Leitstrukturen mittels Gasphasenabscheidung aufgebracht werden.

Dabei ist es möglich, die Leitstrukturen mittels einer physikalischen Gasphasenabscheidung (PVD-Prozess) oder einer chemischen Gasphasenabscheidung (CVD-Prozess) aufzubringen.

Besonders bevorzugt werden die Leitstrukturen partiell aufgebracht. Ein selektives Aufbringen der Leitstrukturen erfolgt bevorzugt mittels Drucken, Sprühen oder mittels PVD/CVD in Verbindung mit einer Maskentechnik, insbesondere einer Schablone.

Eine weitere Möglichkeit zum Aufbringen der Leitstrukturen besteht in dem direkten Drucken von Leiterbahnen auf die elektrisch isolierende Schicht.

Bei einer weiteren bevorzugten Ausgestaltung werden die Leitstrukturen mittels einer anisotropen Schicht gebildet, die auf der elektrisch isolierenden Schicht angeordnet wird und die jeweils zumindest im Bereich der ersten Kontaktfläche der strahlungsemittierenden Halbleiterbauelemente elektrisch leitend ausgebildet wird.

Das Ausbilden der elektrisch leitenden Bereiche der anisotropen Schicht erfolgt bevorzugt mittels eines Druckverfahrens, eines Temperaturverfahrens, oder einer Bestrahlung, beispielsweise mittels eines UV-Lasers.

Alternativ können die Leiterstrukturen in einer Folie integriert sein, die auf die elektrisch isolierende Folie auflaminiert wird. In diesem Fall beinhaltet die auflaminierte Folie Leitstrukturen, beispielsweise Metallisierungen. Diese Leitstrukturen sind bevorzugt bereits in der Folie so angeordnet, dass eine elektrische Kontaktierung der strahlungsemittierenden Halbleiterbauelemente in einer vorgesehenen Art und Weise ermöglicht wird. Besonders bevorzugt findet dazu ein automatisches Kontaktierverfahren (TAB-Verfahren: tape automated bonding) Anwendung.

Bei einer bevorzugten Ausgestaltung des Verfahrens wird vor dem Aufbringen der elektrisch isolierenden Schicht eine Planarisierungsschicht zumindest in die Zwischenräume zwischen den strahlungsemittierenden Halbleiterbauelementen eingebracht. Auf diese Weise wird das Modul so planarisiert, dass eine von dem Trägersubstrat abgewandte Oberfläche des Moduls eben ausgebildet wird.

Bei einer weiteren bevorzugten Ausgestaltung des Verfahrens sind die Leitstrukturen jeweils als elektrisch leitender Steg ausgebildet, wobei die Stege jeweils mittels eines Stanz-Wedge-Prozesses mit der ersten Kontaktfläche eines strahlungsemittierenden Halbleiterbauelements elektrisch leitend verbunden werden.

Weitere Merkmale, Vorteile, bevorzugte Ausgestaltungen und Zweckmäßigkeiten des optoelektronischen Moduls und des Verfahrens zu dessen Herstellung ergeben sich aus den im Folgenden in Verbindung mit den Figuren 1 bis 9 erläuterten Ausführungsbeispielen. Es zeigen:
- Figur 1: einen schematischen Querschnitt eines ersten Beispiels eines Moduls bei einem Zwischenschritt des Herstellungsverfahrens,
- Figur 2: einen schematischen Querschnitt eines weiteren Beispiels eines Moduls,
- Figur 3: einen schematischen Querschnitt eines Beispiels eines Moduls,
- Figur 4: einen schematischen Ausschnitt eines weiteren Beispiels eines Moduls,
- Figur 5: einen schematischen Ausschnitt eines weiteren Beispiels eines Moduls,
- Figur 6: einen schematischen Querschnitt eines weiteren Beispiels eines Moduls,
- Figur 7A: einen schematischen Ausschnitt eines weiteren Beispiels eines Moduls,
- Figur 7B: eine schematische Aufsicht auf den Ausschnitt des Beispiels aus Figur 7A, und
- Figur 7C: eine schematische Aufsicht auf ein weiteres Beispiel eines Moduls.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

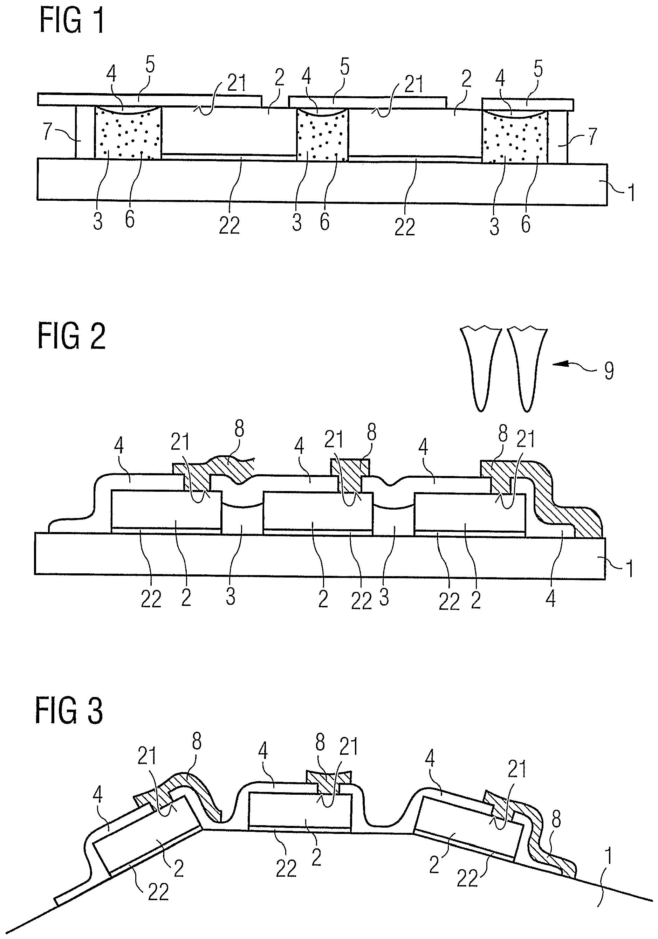

In Figur 1 ist ein optoelektronisches Modul dargestellt, das ein Trägersubstrat 1 und eine Mehrzahl von strahlungsemittierenden Halbleiterbauelementen 2 aufweist. Die strahlungsemittierenden Halbleiterbauelemente 2 weisen jeweils eine aktive Schicht zur Erzeugung von elektromagnetischer Strahlung, eine erste Kontaktfläche 21 und eine zweite Kontaktfläche 22 auf. Die erste Kontaktfläche 21 ist auf der von dem Trägersubstrat 1 abgewandten Oberfläche der strahlungsemittierenden Halbleiterbauelemente 2 angeordnet.

Die strahlungsemittierenden Halbleiterbauelemente 2 sind bevorzugt als Halbleiterchips ausgebildet, besonders bevorzugt jeweils eine Licht emittierende Diode (LED).

Die aktiven Schichten der strahlungsemittierenden Halbleiterbauelemente 2 weisen jeweils einen pn-Übergang, eine Doppelheterostruktur, eine Einfachquantentopfstruktur oder eine Mehrfachquantentopfstruktur zur Strahlungserzeugung auf. Bevorzugt basieren die strahlungsemittierenden Halbleiterbauelemente 2 jeweils auf einem Nitrid-, einem Phosphid- oder einem Arsenid-Verbindungshalbleiter.

Das Trägersubstrat 1 weist zur elektrischen Kontaktierung der strahlungsemittierenden Halbleiterbauelemente 2 strukturierte Leiterbahnen auf. Insbesondere ist bevorzugt jeweils ein strahlungsemittierendes Halbleiterbauelement 2 auf einer Leiterbahn des Trägersubstrats 1 angeordnet. Das bedeutet, dass jeweils die zweite Kontaktfläche 22 im mechanischen und elektrischen Kontakt mit einer Leiterbahn des Trägersubstrats 1 steht.

Bevorzugt sind die Leiterbahnen, auf denen jeweils ein strahlungsemittierendes Halbleiterbauelement 2 angeordnet ist, elektrisch voneinander isoliert. Die strahlungsemittierenden Halbleiterbauelemente 2 sind somit auf den Leiterbahnen des Trägersubstrats 1 elektrisch voneinander isoliert angeordnet.

Bevorzugt ist zwischen den einzelnen strahlungsemittierenden Halbleiterbauelementen 2 eine Planarisierungsschicht 3 angeordnet. Durch die Planarisierungsschicht 3 kann mit Vorteil eine von dem Trägersubstrat 1 abgewandte ebene Oberfläche des Moduls erzeugt werden. Bevorzugt ist die Planarisierungsschicht 3 elektrisch isolierend, besonders bevorzugt enthält die Planarisierungsschicht 3 ein dielektrisches Material.

Bevorzugt basiert die Planarisierungsschicht 3 auf Silikon. Insbesondere enthält die Planarisierungsschicht 3 Silikon. Zusätzlich oder alternativ kann die Planarisierungsschicht 3 andere Polymere oder anorganische Materialien enthalten.

Die Höhe der Planarisierungsschicht 3 kann die Höhe der strahlungsemittierenden Halbleiterbauelemente 2 übersteigen. Insbesondere kann die Planarisierungsschicht 3 über die Höhe der strahlungsemittierenden Halbleiterbauelemente 2 hinaus geführt sein, sodass sie zumindest teilweise über die dem Trägersubstrat 1 abgewandten Oberflächen der strahlungsemittierenden Halbleiterbauelemente 2 verläuft. Dadurch wird insbesondere eine verbesserte elektrische Isolierung der strahlungsemittierenden Halbleiterbauelemente 2 gewährleistet. In diesem Fall besteht die Planarisierungsschicht 3 bevorzugt aus einem für die von den strahlungsemittierenden Halbleiterbauelementen 2 emittierte Strahlung zumindest teilweise strahlungsdurchlässigen Material.

Die Planarisierungsschicht 3 kann ferner zumindest ein Konversionselement 6 enthalten. Bevorzugt absorbiert das Konversionselement 6 die von zumindest einem der strahlungsemittierenden Halbleiterbauelemente 2 emittierte Strahlung und konvertiert diese in Strahlung eines anderen Wellenlängenbereichs, sodass Mischstrahlung der von dem Modul emittierten Strahlung erzeugt wird.

Durch eine gezielte Wahl des Konversionselements 6 kann eine Änderung des Farborts der von den strahlungsemittierenden Halbleiterbauelementen 2 emittierten Strahlung erfolgen. Dadurch kann mit Vorteil ein gewünschter Farbort der von dem Modul emittierten Strahlung erzielt werden. Besonders bevorzugt emittiert das Modul Strahlung im weißen Farbortbereich.

Bevorzugt sind die strahlungsemittierenden Halbleiterbauelemente 2 gemeinsam von einem Rahmen 7, der auf dem Trägersubstrat 1 angeordnet ist, umgeben. Der Rahmen 7 enthält bevorzugt eine Keramik oder einen Kunststoff. In dem Beispiel aus Figur 1 werden mittels des Rahmens 7 die strahlungsemittierenden Halbleiterbauelemente 2 und die Planarisierungsschicht 3 räumlich von der Umgebung abgegrenzt. Mit Vorteil schützt der Rahmen 7 die strahlungsemittierenden Halbleiterbauelemente 2 vor beispielsweise Umwelteinflüssen, wie beispielsweise Stöße.

Auf den strahlungsemittierenden Halbleiterbauelementen 2 und auf der Planarisierungsschicht 3 ist bevorzugt zumindest teilweise eine elektrisch isolierende Schicht 4 angeordnet. Die elektrisch isolierende Schicht 4 weist jeweils eine Aussparung in einem Bereich der ersten Kontaktfläche 21 der strahlungsemittierenden Halbleiterbauelemente 2 auf.

Die elektrisch isolierende Schicht 4 ist bevorzugt für die von der aktiven Schicht emittierte Strahlung der strahlungsemittierenden Halbleiterbauelemente 2 zumindest teilweise strahlungsdurchlässig. Die von den strahlungsemittierenden Halbleiterbauelementen 2 emittierte Strahlung kann so durch die elektrisch isolierende Schicht 4 ausgekoppelt werden, ohne dabei wesentliche optische Verluste zu erleiden.

Die Strahlungsauskopplung der von den strahlungsemittierenden Halbleiterbauelementen 2 emittierten Strahlung aus dem Modul erfolgt in den Beispielen der Figuren 1 bis 7 bevorzugt auf der von dem Trägersubstrat 1 abgewandten Seite des Moduls.

Die elektrisch isolierende Schicht 4 ist bevorzugt eine Folie, ein Lack oder eine Polymerschicht.

Die elektrisch isolierende Schicht 4 kann, genauso wie die Planarisierungsschicht 3, mindestens ein Konversionselement enthalten (nicht dargestellt). Das Konversionselement in der elektrisch isolierenden Schicht absorbiert bevorzugt zumindest teilweise Strahlung der von den strahlungsemittierenden Halbleiterbauelementen 2 emittierten Strahlung und emittiert eine Sekundärstrahlung in einem anderen Wellenlängenbereich. Dadurch emittiert das Modul Mischstrahlung, die sowohl Primärstrahlung der strahlungsemittierenden Halbleiterbauelemente 2 und Sekundärstrahlung des Konversionselements enthält.

Dadurch, dass das Konversionselement oder die Konversionselemente direkt in der elektrisch isolierenden Schicht 4 und/oder in der Planarisierungsschicht 3 integriert sind, sind vorteilhaft keine weiteren zusätzlichen optischen Schichten erforderlich. Optische Schichten sind beispielsweise Schichten, die den Farbort der von den Halbleiterbauelementen emittierten Strahlung gezielt verändern und/oder korrigieren. Eine nahe Konversion der von den Halbleiterbauelementen 2 emittierten Strahlung an den Halbleiterbauelementen 2 kann so mit Vorteil erfolgen. Ein kompaktes Modul wird ermöglicht.

Die elektrisch isolierende Schicht 4 weist bereichsweise Aussparungen auf. Bevorzugt ist jeweils in einem Bereich der ersten Kontaktfläche 21 eines strahlungsemittierenden Halbleiterbauelements 2 eine Aussparung in der elektrisch isolierenden Schicht 4 ausgebildet.

Bevorzugt ist die elektrisch isolierende Schicht 4 einstückig ausgebildet.

Auf der von dem Trägersubstrat 1 abgewandten Oberfläche des Moduls sind bereichsweise auf der elektrisch isolierenden Schicht 4 Leitstrukturen angeordnet (nicht dargestellt).

In dem Beispiel der Figur 1 ist das Modul vor dem Aufbringen der Leitstrukturen dargestellt. Das Modul in dem Beispiel 1 zeigt demnach ein Modul während des Herstellungsprozesses.

In dem Beispiel der Figur 1 ist eine Schablone 5 auf der von dem Trägersubstrat 1 abgewandten Seite des Moduls angeordnet. Die Schablone 5 findet während des Herstellungsschrittes des Aufbringens der Leitstrukturen Anwendung.

Die Schablone 5 wird zur Strukturierung der Leitstrukturen verwendet. Insbesondere weist die Schablone 5 bevorzugt im Bereich der Aussparungen der elektrisch isolierenden Schicht 4 Aussparungen auf.

Die Leitstrukturen werden bevorzugt mittels eines Druckverfahrens auf die elektrisch isolierende Schicht 4 bzw. auf die Schablone 5 aufgebracht. Mittels eines Druckverfahrens, insbesondere eines Siebdruck- oder Tampondruckverfahrens, kann so eine, bevorzugt einlagige, Leitstruktur, insbesondere eine Metallisierungsschicht, zur Verschaltung der strahlungsemittierenden Halbleiterbauelemente 2 aufgebracht werden.

Die Strukturierung der Leitstrukturen wird bevorzugt durch die Schablone 5 so ausgebildet, dass die strahlungsemittierenden Halbleiterbauelemente 2 mittels der Leitstrukturen in einer vorgesehenen Art und Weise miteinander oder mit Leiterbahnen des Trägerkörpers elektrisch leitend verbunden sind. Somit verbinden die Leitstrukturen zumindest die erste Kontaktfläche eines strahlungsemittierenden Halbleiterbauelements 2 mit einer weiteren ersten Kontaktfläche eines weiteren strahlungsemittierenden Halbleiterbauelements 2 oder mit einer Leiterbahn des Trägersubstrats 1 elektrisch (nicht dargestellt).

Nach Aufbringen der Leitstrukturen wird die Schablone 5 entfernt. Die Schablone 5 ist also lediglich zeitweise während des Herstellungsprozesses auf dem Modul angeordnet.

In dem Beispiel der Figur 2 ist ein Beispiel eines fertigen Moduls dargestellt, das Leitstrukturen 8 aufweist. Im Unterschied zu dem in Figur 1 dargestellten Beispiel weist das Modul aus Figur 2 keinen Rahmen auf, der auf dem Trägersubstrat 1 angeordnet ist und die strahlungsemittierenden Halbleiterbauelemente 2 und die Planarisierungsschicht 3 umgibt.

Die strahlungsemittierenden Halbleiterbauelemente 2 sind bevorzugt auf den strukturierten Leiterbahnen des Trägersubstrats 1 mittels eines Lotes oder eines elektrisch leitenden Klebers befestigt.

Wie in dem Beispiel der Figur 1 ist eine elektrisch isolierende Schicht 4 auf den strahlungsemittierenden Bauelementen 2 und der Planarisierungsschicht 3 aufgebracht. Die elektrisch isolierende Schicht 4 weist Aussparungen in Bereichen der ersten Kontaktfläche 21 der strahlungsemittierenden Halbleiterbauelemente 2 auf. Diese Aussparungen werden bevorzugt mittels eines Laserverfahrens oder eines Lithografieverfahrens hergestellt.

Im Gegensatz zu dem Beispiel aus Figur 1 werden die Leitstrukturen 8 beispielsweise mittels eines Jetdruckverfahrens auf die elektrisch isolierende Schicht 4 aufgebracht. Das Aufbringen der Leitstrukturen 8 erfolgt bevorzugt mittels einer Düse 9. Die Düse 9 schreibt die Leitstrukturen, bevorzugt einlagige Metallbahnen, auf die von dem Trägersubstrat 1 abgewandte Seite des Moduls. Insbesondere sind die Leitstrukturen 8 auf der elektrisch isolierenden Schicht 4 so aufgebracht, dass eine elektrische Kontaktierung der strahlungsemittierenden Halbleiterbauelemente 2 untereinander oder mit einer Leiterbahn des Trägersubstrats 1 erfolgt. Insbesondere befinden sich die Leitstrukturen 8 jeweils im Bereich der ersten Kontaktfläche 21 der strahlungsemittierenden Halbleiterbauelemente 2.

Die strahlungsemittierenden Halbleiterbauelemente 2 können so separat geerdet sein. Alternativ können die strahlungsemittierenden Halbleiterbauelemente 2 miteinander elektrisch leitend verbunden sein.

Das Beispiel der Figur 3 unterscheidet sich von dem Beispiel aus Figur 2 dadurch, dass das Trägersubstrat 1 ein flexibles Substrat ist. Insbesondere ist die Oberfläche des Trägersubstrats 1, auf der die strahlungsemittierenden Halbleiterbauelemente 2 angeordnet sind, nicht planar. Das Trägersubstrat 1 kann beispielsweise eine Wölbung aufweisen. Insbesondere kann die Oberfläche des Trägersubstrats 1 auch andere Formungen aufweisen, solange eine Montage der strahlungsemittierenden Halbleiterbauelemente 2 möglich ist.

Insbesondere kann das Modul in dem Beispiel der Figur 3 rotierbar gelagert sein. Dadurch vereinfacht sich mit Vorteil beispielsweise die Herstellung des Moduls. Während des Verfahrensschrittes des Schreibens der Leitstrukturen mittels einer Düse kann das Modul beispielsweise entsprechend einer gewünschten Strukturierung der Leitstrukturen bewegt, beispielsweise rotiert, werden.

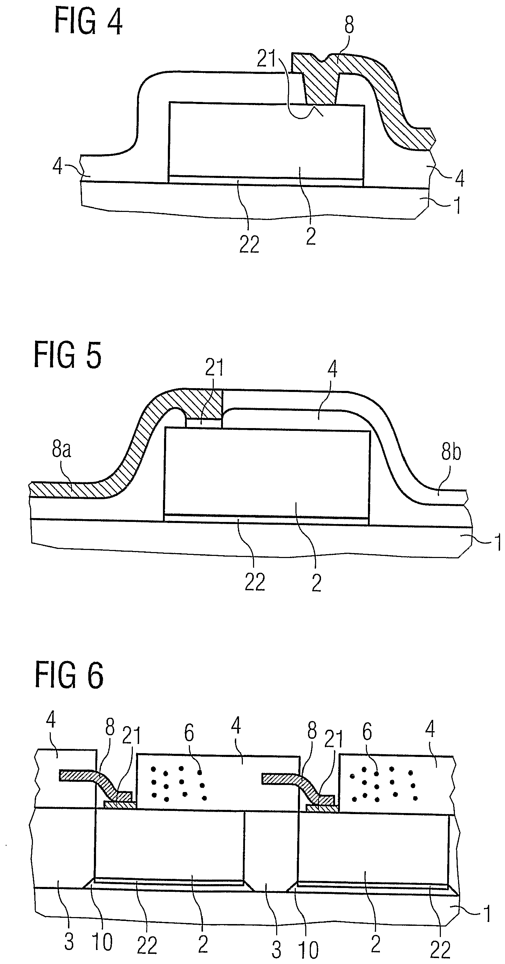

In dem Beispiel der Figur 4 ist ein Ausschnitt eines optoelektronischen Moduls dargestellt. Insbesondere ist lediglich ein strahlungsemittierendes Halbleiterbauelement 2 des Moduls dargestellt. Die weiteren strahlungsemittierenden Halbleiterbauelemente des Moduls sind der Übersicht halber nicht gezeigt.

Auf einem Trägersubstrat 1 sind strahlungsemittierende Halbleiterbauelemente 2 bevorzugt mittels einer adhäsiven Schicht aufgeklebt oder mittels eines Lotes aufgelötet. Wie in Figur 4 dargestellt, ist bevorzugt auf den strahlungsemittierenden Halbleiterbauelementen 2 und auf dem Trägersubstrat 1 eine elektrisch isolierende Schicht 4 angeordnet. Die elektrisch isolierende Schicht 4 ist beispielsweise eine auflaminierte Folie oder eine Schicht, die Glas umfasst.

Die elektrisch isolierende Schicht 4 weist eine Aussparung im Bereich der ersten Kontaktfläche 21 des strahlungsemittierenden Halbleiterbauelements 2 auf. Die elektrisch isolierende Schicht 4 ist bevorzugt eine dielektrische Schicht.

Bevorzugt wird während des Herstellungsprozesses des Moduls auf die elektrisch isolierende Schicht 4 eine Leitstruktur, besonders bevorzugt eine Metallschicht, mittels Gasphasenabscheidung ganzflächig abgeschieden (nicht dargestellt). Bevorzugt wird die ganzflächige Leitstruktur mittels physikalischer oder chemischer Gasphasenabscheidung abgeschieden. Anschließend wird die ganzflächig ausgebildete Leitstruktur beispielsweise mittels Fotolithografie und Ätzung entsprechend einer gewünschten Verschaltung der strahlungsemittierenden Halbleiterbauelemente 2 strukturiert. Insbesondere wird die ganzflächige Leitstruktur bevorzugt so strukturiert, dass die strahlungsemittierenden Halbleiterbauelemente miteinander elektrisch leitend verbunden werden oder ein strahlungsemittierendes Halbleiterbauelement 2 mit einer Leiterbahn des Trägersubstrats 1 elektrisch leitend verbunden wird. Bevorzugt wird zur vereinfachten und verbesserten Prozessführung die elektrisch isolierende Schicht, insbesondere die dielektrische Schicht, vor dem Abscheiden der Leitstruktur planarisiert, beispielsweise mittels eines SOG-Verfahrens.

In dem Beispiel zu Figur 5 ist ein Ausschnitt eines weiteren optoelektronischen Moduls dargestellt. Auch in diesem Fall ist der Übersicht halber lediglich ein strahlungsemittierendes Halbleiterbauelement 2 dargestellt. Im Unterschied zu dem in Figur 4 dargestellten Beispiel ist die Leitstruktur 8 durch eine anisotrope Schicht 8a, 8b gebildet. Bevorzugt ist die anisotrope Schicht 8a, 8b eine anisotrope Folie, die vorzugsweise auflaminiert wird.

Die anisotrope Schicht weist bevorzugt zwei Teilbereiche 8a, 8b auf. Einer der Teilbereiche 8a ist bevorzugt leitfähig ausgebildet. Ein anderer Teilbereich 8b dagegen ist elektrisch isolierend.

Die Ausbildung der Leitfähigkeit im Bereich 8a der anisotropen Schicht erfolgt bevorzugt durch einen lokal applizierten Druck oder eine Bestrahlung. Dadurch wird mit Vorteil ein elektrischer Anschluss des strahlungsemittierenden Halbleiterbauelements 2 im Bereich der ersten Kontaktfläche 21 gewährleistet.

Die anistrope Schicht 8a, 8b ist bevorzugt in dem zweiten Teilbereich 8b für die von dem strahlungsemittierenden Halbleiterbauelement 2 emittierte Strahlung zumindest teilweise strahlungsdurchlässig. Alternativ kann die anisotrope Schicht 8a, 8b in dem zweiten Teilbereich 8b nach Auflaminieren selektiv entfernt werden. In diesem Fall muss die anisotrope Schicht 8a, 8b nicht strahlungsdurchlässig sein.

Das in Figur 6 dargestellte Beispiel eines optoelektronischen Moduls weist eine Mehrzahl von strahlungsemittierenden Halbleiterbauelementen 2 auf, die mittels eines Lotes oder einer adhäsiven Schicht 10 auf einem Trägersubstrat 1 befestigt sind. Bevorzugt stehen zweite Kontaktflächen 22 der strahlungsemittierenden Halbleiterbauelemente 2 in elektrischem Kontakt mit Leiterbahnen, die auf dem Trägersubstrat 1 angeordnet sind. Die Leiterbahnen der strahlungsemittierenden Halbleiterbauelemente 2 sind bevorzugt voneinander elektrisch isoliert angeordnet.

Im Gegensatz zu den in den vorherigen Beispielen dargestellten Modulen werden in dem Beispiel der Figur 6 die elektrisch isolierende Schicht 4 durch eine strukturierte Leiterplatte und die Leitstrukturen 8 durch aus der Leiterplatte herausragende, elektrisch leitende Stege, beispielsweise Metallstege, gebildet.

Die Leiterplatte weist insbesondere ein elektrisch isolierendes Material mit darin enthaltenen elektrisch leitenden Leiterbahnen auf. Besonders bevorzugt ist das elektrisch isolierende Material der Leiterplatte für die von den strahlungsemittierenden Halbleiterbauelementen 2 emittierte Strahlung zumindest teilweise strahlungsdurchlässig. Das elektrisch isolierende Material der Leiterplatte kann ferner zumindest ein Konversionselement enthalten, um die von den strahlungsemittierenden Halbleiterbauelementen 2 emittierte Strahlung zu konvertieren.

Die in dem elektrisch isolierenden Material der Leiterplatte enthaltenen Leiterbahnen sind bevorzugt zumindest teilweise elektrisch leitend mit den Metallstegen 8 verbunden. Ferner sind die Metallstege 8 jeweils bevorzugt mit der ersten Kontaktfläche 21 eines strahlungsemittierenden Halbleiterbauelements 2 elektrisch leitend verbunden. Dazu weist die Leiterplatte 4 jeweils eine Aussparung im Bereich der ersten Kontaktfläche 21 eines strahlungsemittierenden Halbleiterbauelements 2 auf.

Über die Stege 8 und über die Leiterbahnen der Leiterplatte 4 werden die strahlungsemittierenden Halbleiterbauelemente 2 jeweils elektrisch kontaktiert. Dabei können die strahlungsemittierenden Halbleiterbauelemente 2 elektrisch leitend miteinander verbunden oder elektrisch leitend jeweils mit einer Leiterbahn des Trägersubstrats 1 verbunden sein. Die Metallstege 8 sind bevorzugt so geformt, dass sie von der Kontaktstelle der Leiterplatte in Richtung der strahlungsemittierenden Halbleiterbauelemente 2 gekrümmt sind.

Bei diesem Beispiel können auch mehrere Leiterplatten übereinander angeordnet sein, sodass eine mehrlagige Anordnung und somit mehrlagige Verschaltungsebenen in dem Modul ausgebildet sind (nicht dargestellt).

Die Metallstege 8 können beispielsweise jeweils mit einem Stanz-Wedge-Prozess mit der ersten Kontaktfläche 21 der strahlungsemittierenden Halbleiterbauelemente 2 elektrisch und mechanisch verbunden werden.

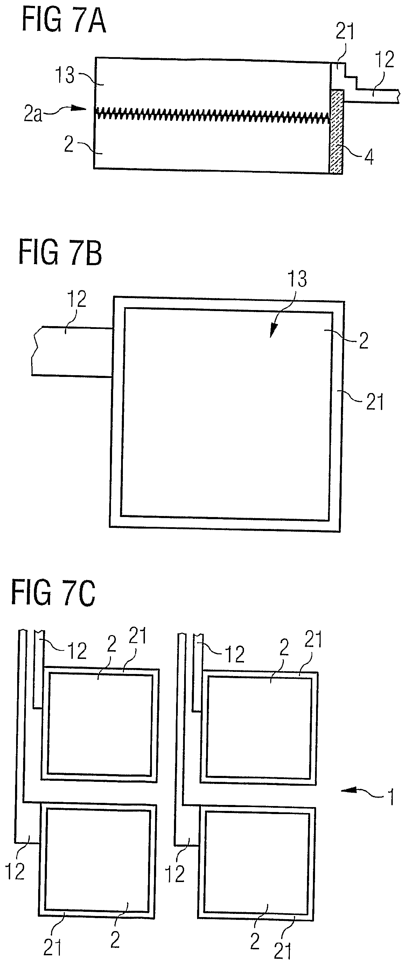

In den Figuren 7A und 7B ist jeweils ein schematischer Ausschnitt eines optoelektronischen Moduls dargestellt. Figur 7A stellt einen Querschnitt eines Ausschnitts eines Moduls dar. Figur 7B zeigt dazu eine Aufsicht auf den Ausschnitt aus Figur 7A.

In Figur 7A ist ein strahlungsemittierendes Halbleiterbauelement 2 gezeigt. Ein optoelektronisches Modul setzt sich bevorzugt aus mehreren strahlungsemittierenden Halbleiterbauelementen 2, das beispielsweise in Figur 7A dargestellt ist, zusammen, wobei die strahlungsemittierenden Halbleiterbauelemente 2 bevorzugt auf einem Trägersubstrat 1 angeordnet sind.

Das strahlungsemittierende Halbleiterbauelement 2 aus Figur 7A weist, im Unterschied zu den Beispielen der Figuren 1 bis 6, eine erste Kontaktfläche 21 auf, die auf der elektrisch isolierenden Schicht 4 geführt ist. Die elektrisch isolierende Schicht 4 ist dazu jeweils bereichsweise an den Seitenflächen des strahlungsemittierenden Halbleiterbauelements 2 um das jeweilige strahlungsemittierende Halbleiterbauelement 2 geführt. Bevorzugt ist die elektrisch isolierende Schicht 4 an den Seitenflächen des strahlungsemittierenden Halbleiterbauelements 2 über die aktive Schicht 2a des Halbleiterbauelements 2 geführt.

Bevorzugt ist die erste Kontaktschicht 21 ebenfalls an der Seitenfläche des Halbleiterbauelements 2 geführt. Insbesondere ist die erste Kontaktschicht 21 auf der elektrisch isolierenden Schicht 4 geführt. Die von dem Trägersubstrat abgewandte Oberfläche des strahlungsemittierenden Halbleiterbauelements 2 ist dabei bevorzugt frei von der ersten Kontaktfläche 21.

Durch die Führung der ersten Kontaktschicht 21 entlang den Seitenflächen des Halbleiterbauelements 2 kann eine homogene Bestromung des strahlungsemittierenden Halbleiterbauelements 2 gewährleistet werden.

Bevorzugt schließt an einen Bereich der ersten Kontaktschicht 21 eine elektrische Zuführung 12 an. Durch die Führung der ersten Kontaktschicht 21 entlang den Seitenflächen des Halbleiterbauelements 2 können an beliebigen Bereichen der ersten Kontaktschicht 21 elektrische Zuführungen 12 zur elektrischen Verschaltung der Halbleiterbauelemente 2 geführt sein. Die Halbleiterbauelemente eines Moduls können so über die Zuführungen 12 miteinander elektrisch verschaltet sein. Alternativ können die Halbleiterbauelemente getrennt voneinander elektrisch angeschlossen sein.

In Figur 7B ist eine Aufsicht auf die Kontaktführung eines Halbleiterbauelements aus Figur 7A dargestellt. Die erste Kontaktschicht 21 ist dabei seitlich einer Strahlungsauskoppelfläche des Halbleiterbauelements 2 angeordnet. Bevorzugt ist die erste Kontaktschicht 21 rahmenförmig ausgebildet. Insbesondere bildet die erste Kontaktschicht 21 eine geschlossene Bahn. Bereichsweise an die erste Kontaktschicht 21 ist eine elektrische Zuführung 12 angeordnet, die zur Verschaltung des Halbleiterbauelements 2 dient.

Bevorzugt ist in den Beispielen der Figuren 7a, 7b auf dem strahlungsemittierenden Halbleiterbauelement 2 eine Stromverteilungsschicht 13 angeordnet. Insbesondere ist die Stromverteilungsschicht 13 für die von dem Halbleiterbauelement 2 emittierte Strahlung zumindest teilweise strahlungsdurchlässig. Beispielsweise ist die Stromverteilungsschicht 13 eine ITO-Schicht oder eine ZnO-Schicht.

Die erste Kontaktschicht 21 ist bevorzugt eine Metallisierung. Die Strahlungsauskoppelfläche des Halbleiterbauelements 2 ist bevorzugt frei von der Metallisierung. Bevorzugt ist die Metallisierung um das Halbleiterbauelement 2 herumgeführt, wodurch eine homogenere Bestromung gewährleistet wird als bei beispielsweise durch herkömmlicherweise verwendete Bondpads.

In Figur 7C ist eine Aufsicht auf ein Modul mit einer Mehrzahl von strahlungsemittierenden Halbleiterbauelementen 2 aus Figur 7A dargestellt. In diesem Fall weist das Modul vier strahlungsemittierende Halbleiterbauelemente 2 auf. Es ist jedoch eine alternative Anzahl an Halbleiterbauelementen 2 möglich, abhängig von den jeweiligen Anwendungsbereichen und Verwendungszwecken des Moduls.

Durch die seitlich angeordnete elektrische Führung der ersten Kontaktfläche 21 der Halbleiterbauelemente 2 ermöglicht sich eine komplexe Verschaltung der Halbleiterbauelemente 2. Eine Platz sparende Anordnung der Halbleiterbauelemente 2 auf dem Trägersubstrat 1 ist dadurch mit Vorteil möglich.

Insbesondere besteht die Möglichkeit, die Halbleiterbauelemente 2 einzeln auf das Trägersubstrat 1 zu montieren und getrennt voneinander elektrisch leitend anzuschließen. In diesem Fall weist das Trägersubstrat 1 auf der Montageseite für die Halbleiterbauelemente 2 jeweils voneinander elektrisch isolierte Leiterbahnen auf, auf denen jeweils ein Halbleiterbauelement mechanisch und elektrisch angeschlossen ist.

Alternativ können die Halbleiterbauelemente 2 miteinander elektrisch verschaltet sein. Dabei ist bevorzugt das Trägersubstrat 1 selbst elektrisch leitend ausgebildet, sodass die Halbleiterbauelemente 2 auf einem gemeinsamen elektrischen Potential liegen. Alternativ kann auf dem Trägersubstrat 1 eine Leiterbahn angeordnet sein, auf der die Halbleiterbauelemente 2 gemeinsam angeordnet sind. Die elektrischen Zuführungen 12 der Halbleiterbauelemente 2 sind bevorzugt zu einem weiteren elektrischen Anschluss geführt (nicht dargestellt).

Die Erfindung ist nicht durch die Beschreibung anhand der Ausführungsbeispiele auf diese beschränkt, sondern umfasst jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Modul, das ein Trägersubstrat (1) und eine Mehrzahl von strahlungsemittierenden Halbleiterbauelementen (2) aufweist, wobei
- das Trägersubstrat (1) zur elektrischen Kontaktierung der strahlungsemittierenden Halbleiterbauelemente (2) strukturierte Leiterbahnen aufweist,
- die strahlungsemittierenden Halbleiterbauelemente (2) jeweils eine zur Erzeugung von elektromagnetischer Strahlung geeignete aktive Schicht (2a), eine erste Kontaktfläche (21) und eine zweite Kontaktfläche (22) aufweisen, wobei die erste Kontaktfläche (21) jeweils auf der von dem Trägersubstrat (1) abgewandten Seite der strahlungsemittierenden Halbleiterbauelemente (2) angeordnet ist,
- zumindest zwischen den strahlungsemittierenden Halbleiterbauelementen (2) eine Planarisierungsschicht (3) angeordnet ist,
- die strahlungsemittierenden Halbleiterbauelemente (2) mit einer elektrisch isolierenden Schicht (4) versehen sind, die zumindest teilweise auf der Planarisierungsschicht (3) angeordnet ist und die jeweils eine Aussparung in einem Bereich der ersten Kontaktfläche (21) der strahlungsemittierenden Halbleiterbauelemente (2) aufweist,
- auf der elektrisch isolierenden Schicht (4) bereichsweise Leitstrukturen (8) angeordnet sind, und **dadurch gekennzeichnet, dass**
- eine der Leitstrukturen zumindest die erste Kontaktfläche (21) eines strahlungsemittierenden Halbleiterbauelements (2) mit einer weiteren ersten Kontaktfläche eines weiteren strahlungsemittierenden Halbleiterbauelements (2) oder mit einer Leiterbahn des Trägersubstrats (1) elektrisch leitend verbindet,
- die Leitstrukturen in eine Folie integriert sind, und
- das Trägersubstrat (1) ein flexibles Substrat ist.

2. Modul gemäß Anspruch 1, wobei
die Planarisierungsschicht (3) zumindest ein Konversionselement enthält.

3. Modul gemäß einem der vorhergehenden Ansprüche, wobei die elektrisch isolierende Schicht (4) zumindest ein Konversionselement (6) enthält.

4. Modul gemäß einem der vorhergehenden Ansprüche, wobei die strahlungsemittierenden Halbleiterbauelemente (2) gemeinsam von einem Rahmen (7), der auf dem Trägersubstrat (1) angeordnet ist, umgeben sind.

5. Modul gemäß einem der vorhergehenden Ansprüche, wobei die Oberfläche des Trägersubstrats (1), auf der die strahlungsemittierenden Halbleiterbauelemente (2) angeordnet sind, nicht planar ist.

6. Verfahren zum Herstellen eines optoelektronischen Moduls mit den Verfahrensschritten:
- Anordnen einer Mehrzahl von strahlungsemittierenden Halbleiterbauelementen (2) auf einem Trägersubstrat (1), wobei
das Trägersubstrat (1) zur elektrischen Kontaktierung der strahlungsemittierenden Halbleiterbauelemente (2) strukturierte Leiterbahnen aufweist,
die strahlungsemittierenden Halbleiterbauelemente (2) jeweils eine zur Erzeugung von elektromagnetischer Strahlung geeignete aktive Schicht (2a), eine erste Kontaktfläche (21) und eine zweite Kontaktfläche (22) aufweisen, wobei jeweils die erste Kontaktfläche (21) auf der von dem Trägersubstrat (1) abgewandten Seite der strahlungsemittierenden Halbleiterbauelemente (2) angeordnet ist,
- Anordnen einer Planarisierungsschicht (3) zwischen den strahlungsemittierenden Halbleiterbauelementen (2),
- zumindest teilweises Aufbringen einer elektrisch isolierenden Schicht (4) auf die strahlungsemittierenden Halbleiterbauelemente (2) und die Planarisierungsschicht (3), wobei die elektrisch isolierende Schicht (4) jeweils eine Aussparung (4a) im Bereich der ersten Kontaktfläche (21) des jeweiligen strahlungsemittierenden Halbleiterbauelements (2) aufweist, und **dadurch gekennzeichnet, dass**
- Leitstrukturen (8) auf Teilbereiche der elektrisch isolierenden Schicht (4) aufgebracht werden, wobei eine der Leitstrukturen (8) zumindest die erste Kontaktfläche (21) eines strahlungsemittierenden Halbleiterbauelements (2) mit einer weiteren ersten Kontaktfläche (21) eines weiteren strahlungsemittierenden Halbleiterbauelements (2) oder mit einer Leiterbahn des Trägersubstrats (1) elektrisch leitend verbindet,
- die Leitstrukturen in eine Folie integriert sind, und
- das Trägersubstrat (1) ein flexibles Substrat ist.

## Claims

1. An optoelectronic module comprising a carrier substrate (1) and a plurality of radiation emitting semiconductor devices (2), wherein
- the carrier substrate (1) has structured conductor tracks for making electrical contact with the radiation-emitting semiconductor components (2),
- the radiation-emitting semiconductor components (2) each have an active layer (2a) suitable for generating electromagnetic radiation, a first contact surface (21) and a second contact surface (22), the first contact surface (21) being arranged in each case on the side of the radiation-emitting semiconductor components (2) facing away from the carrier substrate (1),
- a planarization layer (3) is arranged at least between the radiation-emitting semiconductor components (2),
- the radiation-emitting semiconductor components (2) are provided with an electrically insulating layer (4) which is arranged at least partially on the planarization layer (3) and which in each case has a recess in a region of the first contact surface (21) of the radiation-emitting semiconductor components (2),
- conductive structures (8) are arranged in regions on the electrically insulating layer (4), and
**characterised in that**
- one of the conductive structures electrically conductively connects at least the first contact surface (21) of a radiation-emitting semiconductor component (2) to a further first contact surface of a further radiation-emitting semiconductor component (2) or to a conductor track of the carrier substrate (1),
- the conductive structures are integrated into a film, and
- the carrier substrate (1) is a flexible substrate.

2. The module according to claim 1,
wherein the planarization layer (3) contains at least one conversion element.

3. The module according to one of the preceding claims, wherein the electrically insulating layer (4) contains at least one conversion element (6).

4. The module according to one of the preceding claims, wherein the radiation-emitting semiconductor components (2) are jointly surrounded by a frame (7) disposed on the carrier substrate (1).

5. The module according to one of the preceding claims, wherein the surface of the carrier substrate (1) on which the radiation-emitting semiconductor components (2) are arranged is non-planar.

6. A method for producing an optoelectronic module comprising the steps of
- arranging a plurality of radiation-emitting semiconductor components (2) on a carrier substrate (1), wherein the carrier substrate (1) has structured conductor tracks for making electrical contact with the radiation-emitting semiconductor components (2),the radiation-emitting semiconductor components (2) each have an active layer (2a) suitable for generating electromagnetic radiation, a first contact surface (21) and a second contact surface (22), the first contact surface (21) in each case being arranged on the side of the radiation-emitting semiconductor components (2) facing away from the carrier substrate (1),
- arranging a planarization layer (3) between the radiation-emitting semiconductor components (2),
- at least partially applying an electrically insulating layer (4) to the radiation-emitting semiconductor components (2) and the planarization layer (3), the electrically insulating layer (4) having in each case a recess (4a) in the region of the first contact surface (21) of the respective radiation-emitting semiconductor component (2), and
**characterised in that**
- conductive structures (8) are applied to partial regions of the electrically insulating layer (4), one of the conductive structures (8) electrically conductively connecting at least the first contact surface (21) of a radiation-emitting semiconductor component (2) to a further first contact surface (21) of a further radiation-emitting semiconductor component (2) or to a conductor track of the carrier substrate (1),
- the lead structures are integrated into a foil, and
- the carrier substrate (1) is a flexible substrate.

## Revendications

1. Module optoélectronique qui présente un substrat de support (1) et une pluralité de composants semi-conducteurs émetteurs de rayonnement (2),
- le substrat de porteur (1) présentant des pistes conductrices structurées destinées à mettre en contact électrique les composants semi-conducteurs émetteurs de rayonnement (2),
- les composants semi-conducteurs émetteurs de rayonnement (2) présentant chacun une couche active (2a) apte à générer un rayonnement électromagnétique, une première surface de contact (21) et une deuxième surface de contact (22), chacune des premières surfaces de contact (21) étant agencée sur la face des composants semi-conducteurs émetteurs de rayonnement (2) qui est opposée au substrat de support (1),
- une couche de planarisation (3) étant au moins agencée entre les composants semi-conducteurs émetteurs de rayonnement (2),
- les composants semi-conducteurs émetteurs de rayonnement (2) étant pourvus d'une couche électro-isolante (4) qui est agencée au moins partiellement sur la couche de planarisation (3) et qui présente respectivement un évidement dans une zone de la première surface de contact (21) des composants semi-conducteurs émetteurs de rayonnement (2),
- des structures conductrices (8) étant agencées dans certaines zones sur la couche électro-isolante (4), et **caractérisé en ce que**
- une des structures conductrices connecte de manière électroconductrice au moins la première surface de contact (21) d'un composant semi-conducteur émetteur de rayonnement (2) à une autre première surface de contact d'un autre composant semi-conducteur émetteur de rayonnement (2) ou à une piste conductrice du substrat de support (1),
- les structures conductrices sont intégrées dans un film, et
- le substrat de support (1) est un substrat souple.

2. Module selon la revendication 1,
la couche de planarisation (3) contenant au moins un élément de conversion.

3. Module selon l'une quelconque des revendications précédentes,
la couche électro-isolante (4) contenant au moins un élément de conversion (6).

4. Module selon l'une quelconque des revendications précédentes,
les composants semi-conducteurs émetteurs de rayonnement (2) étant entourés de manière collective par un cadre (7) qui est agencé sur le substrat de support (1).

5. Module selon l'une quelconque des revendications précédentes,
la surface du substrat de support (1) sur laquelle les composants semi-conducteurs émetteurs de rayonnement (2) sont agencés n'étant pas planaire.

6. Procédé de fabrication d'un module optoélectronique comprenant les étapes de procédé :
- disposer une pluralité de composants semi-conducteurs émetteurs de rayonnement (2) sur un substrat de support (1),
le substrat de porteur (1) présentant des pistes conductrices structurées destinées à mettre en contact électrique les composants semi-conducteurs émetteurs de rayonnement (2),
les composants semi-conducteurs émetteurs de rayonnement (2) présentant chacun une couche active (2a) apte à générer un rayonnement électromagnétique, une première surface de contact (21) et une deuxième surface de contact (22), chacune des premières surfaces de contact (21) étant agencée sur la face des composants semi-conducteurs émetteurs de rayonnement (2) qui est opposée au substrat de support (1),
- disposer une couche de planarisation (3) entre les composants semi-conducteurs émetteurs de rayonnement (2),
- appliquer au moins partiellement une couche électro-isolante (4) sur les composants semi-conducteurs émetteurs de rayonnement (2) et sur la couche de planarisation (3), chacune des couches électro-isolantes (4) présentant un évidement (4a) dans la zone de la première surface de contact (21) du composant semi-conducteur émetteur de rayonnement (2) correspondant, et **caractérisé en ce que**
- des structures conductrices (8) sont appliquées sur des zones partielles de la couche électro-isolante (4), une des structures conductrices (8) connectant de manière électroconductrice au moins la première surface de contact (21) d'un composant semi-conducteur émetteur de rayonnement (2) à une autre première surface de contact (21) d'un autre composant semi-conducteur émetteur de rayonnement (2) ou à une piste conductrice du substrat de support (1),
- les structures conductrices sont intégrées dans un film, et
- le substrat de support (1) est un substrat souple.
